# EUROPÄISCHE PATENTSCHRIFT

(11) **EP 4 406 370 B1**
(45) Veröffentlichungstag und Bekanntmachung des Hinweises auf die Patenterteilung: **06.08.2025**
(21) Anmeldenummer: 22813264.3
(22) Anmeldetag: 07.11.2022
(51) Int. Cl.: H05K 1/02, H05K 1/11, H05K 1/18

(54) **LEITERPLATTE FÜR EIN LED-MODUL, LED-MODUL UND LED-LEUCHTEN**
PRINTED CIRCUIT BOARD FOR AN LED MODULE, LED MODULE, AND LED LIGHTS
CARTE DE CIRCUIT IMPRIMÉ POUR MODULE DE DEL, MODULE DE DEL ET LUMIÈRE À DEL

(30) Priorität: 09.11.2021 DE 202021106104 U
(43) Veröffentlichungstag der Anmeldung: 31.07.2024
(73) Patentinhaber: Zumtobel Lighting GmbH, 6850 Dornbirn (AT); Thorn Lighting Limited, Spennymoor, Durham DL16 6HL (GB)
(72) Erfinder: ARCHER, Peter, Durham DL5 4XE (GB); DESTA, Tamrat, 6850 Dornbirn (AT); OLARIU, Cristian, 6850 Dornbirn (AT)
(74) Vertreter: Rupp, Christian
(86) Internationale Anmeldenummer: PCT/EP2022/080913
(87) Internationale Veröffentlichungsnummer: WO 2023/083728

(56) Entgegenhaltungen:
- EP-A2- 1 233 661
- DE-A1- 102019 217 344
- DE-U1- 202018 104 566
- US-A- 5 112 230
- US-A1- 2017 006 710

## Beschreibung

### FACHGEBIET

Die vorliegende Offenbarung aus dem Fachgebiet der Beleuchtungstechnik betrifft eine Leiterplatte für ein LED-Modul, ein LED-Modul mit dieser Leiterplatte, sowie LED-Leuchten mit diesem LED-Modul.

### HINTERGRUND

In der Beleuchtungstechnik werden zunehmend Leuchten mit separat ansteuerbaren Lichtfeldern nachgefragt, wie etwa ein kreisförmiges Lichtfeld mit einem umlaufenden ringförmigen Lichtfeld ("Halo").

Da solche Anordnungen jedoch nur einen Teil der Fertigung ausmachen, müssten verschiedene Leiterplatten für Leuchten mit bzw. ohne separat ansteuerbaren Lichtfeldern vorgesehen werden, mit entsprechend aufwändigerer Entwicklung bzw. Fertigung und größerem Lagerbedarf.

DE 20 2018 104566 U1 offenbart eine Leiterplatte für ein LED-Modul mit einem Steckverbinder mit vier Anschlüssen. Zwischen einem ersten Anoden-Kathoden-Paar der vier Anschlüsse ist eine erste LED-Lichtquelle anschließbar und zwischen einem zweiten Anoden-Kathoden-Paar der vier Anschlüsse ist eine zweite LED-Lichtquelle anschließbar.

DE 10 2019 217 344 A1 beschreibt ein Beleuchtungsmodul mit einem Schaltungsträger. Lichtquellen sind zwischen zwei Strängen von Leitungsbahnen in Reihe auf dem Schaltungsträger angeordnet.

US 2017/006710 A1 zeigt ein flexibles Substrat für die Anordnung von LEDs und ein entsprechendes Verfahren. Dabei werden zwei Leiterbahnen verwendet, wobei die LEDs jeweils mit unteschiedlichen Abständen zu den Leiterbahnen platziert werden.

US 5 112230 A betrifft ein Substrat für elektrische Verbindungen. Auch hier verbinden Leiterbahnen auf einem Substrat elektrische Vorrichtungen.

EP 123 61 A2 offenbart ein Montageverfahren für eine Leiterplatte. Dabei wird nach der Aufbringung einer elektrischen Schaltung die Anpassung eines elektrischen Parameters der Schaltung vorgenommen.

### ZUSAMMENFASSUNG DER ERFINDUNG

Es besteht daher ein Bedarf an Leiterplatten, welche eine Entwicklung bzw. Fertigung sowie eine Vorratshaltung entlasten.

Diese Aufgabe wird erfindungsgemäß durch eine Leiterplatte für ein LED-Modul mit den Merkmalen des Schutzanspruchs 1, durch ein LED-Modul mit den Merkmalen des Schutzanspruchs 5, sowie durch LED-Leuchten mit den jeweiligen Merkmalen der Schutzansprüche 6 bis 9 gelöst. Die abhängigen Ansprüche definieren Ausführungsformen der Erfindung.

Eine Leiterplatte für ein LED-Modul gemäß einem ersten Aspekt umfasst mechanische Schwächungen in einem Substrat der Leiterplatte, die zumindest eine zumindest elektrisch unterbrechbare Substratbrücke bilden; und einen Steckverbinder mit vier Anschlüssen. Zwischen einem ersten Anoden-Kathoden-Paar der vier Anschlüsse ist eine erste LED-Lichtquelle anschließbar. Zwischen einem zweiten Anoden-Kathoden-Paar der vier Anschlüsse ist eine zweite LED-Lichtquelle anschließbar.

Ein Anoden-Paar der vier Anschlüsse ist über eine erste der zumindest einen Substratbrücke galvanisch miteinander verbunden. Die Leiterplatte ist durch den Steckverbinder je nach Zustand der zumindest einen Substratbrücke über zwei oder drei separate galvanische Verbindungen an zumindest einen LED-Treiber für das LED-Modul anschließbar.

Gemäß einem Ausführungsbeispiel kann die zumindest eine Substratbrücke aus dem Substrat der Leiterplatte ausstanzbar oder heraustrennbar sein.

Gemäß einem Ausführungsbeispiel umfasst die Leiterplatte Lötanschlüsse an Enden der jeweiligen Substratbrücke zum nachträglichen galvanischen Überbrücken der jeweiligen Substratbrücke.

Gemäß einem Ausführungsbeispiel umfasst die Leiterplatte zumindest eine federbelastete Leiterbrücke zum nachträglichen galvanischen Überbrücken der jeweiligen Substratbrücke zwischen den Lötanschlüssen.

Gemäß einem Ausführungsbeispiel umfasst die zumindest eine Substratbrücke zwei Substratbrücken, ist ein Kathoden-Paar der vier Anschlüsse über eine zweite der zumindest einen Substratbrücke galvanisch miteinander verbunden, und ist die Leiterplatte durch den Steckverbinder je nach Zustand der zumindest einen Substratbrücke über zwei, drei oder vier separate galvanische Verbindungen an den zumindest einen LED-Treiber für das LED-Modul anschließbar.

Ein LED-Modul gemäß einem zweiten Aspekt umfasst eine Leiterplatte gemäß dem ersten Aspekt mit der ersten LED-Lichtquelle und der zweiten LED-Lichtquelle.

Eine LED-Leuchte gemäß einem dritten Aspekt umfasst ein LED-Modul gemäß dem zweiten Aspekt mit intakten Substratbrücken; und einen LED-Treiber zum gemeinsamen Betreiben der ersten LED-Lichtquelle und der zweiten LED-Lichtquelle. Der LED-Treiber ist hierzu über zwei separate galvanische Verbindungen des Steckverbinders der Leiterplatte des LED-Moduls angeschlossen.

Eine LED-Leuchte gemäß einem vierten Aspekt umfasst ein LED-Modul gemäß dem zweiten Aspekt mit unterbrochener erster Substratbrücke der Substratbrücken; und einen Zweikanal-LED-Treiber zum voneinander unabhängigen Betreiben der ersten LED-Lichtquelle und der zweiten LED-Lichtquelle. Der LED-Treiber ist dabei über drei separate galvanische Verbindungen des Steckverbinders der Leiterplatte des LED-Moduls angeschlossen.

Eine LED-Leuchte gemäß einem fünften Aspekt umfasst ein LED-Modul gemäß dem zweiten Aspekt mit unterbrochenen Substratbrücken; und einen Zweikanal-LED-Treiber zum voneinander unabhängigen Betreiben der ersten LED-Lichtquelle und der zweiten LED-Lichtquelle. Der LED-Treiber ist hierfür über zwei separate Paare von galvanischen Verbindungen des Steckverbinders der Leiterplatte des LED-Moduls angeschlossen.

Eine LED-Leuchte gemäß einem sechsten Aspekt umfasst ein LED-Modul gemäß dem zweiten Aspekt mit unterbrochenen Substratbrücken; und separate erste und zweite LED-Treiber zum voneinander unabhängigen Betreiben der ersten LED-Lichtquelle und der zweiten LED-Lichtquelle. Dafür sind die LED-Treiber über zwei separate Paare von galvanischen Verbindungen des Steckverbinders der Leiterplatte des LED-Moduls angeschlossen.

### VORTEILE DER ERFINDUNG

Die mechanischen Schwächungen in dem Substrat der Leiterplatte ermöglichen die Verwendung einer einheitlich gestalteten Leiterplatte für verschiedene Beleuchtungsanwendungen. Dies entlastet eine Entwicklung bzw. Fertigung sowie eine Vorratshaltung. Ferner können auch geringe Absatzvolumina aus einen einheitlichen Bausatz gefertigt werden - mithin auch solche, die ohne die einheitlich gestaltete Leiterplatte unwirtschaftlich wären. Insgesamt wird also eine Kostenposition verbessert - auch weil keine weiteren Komponenten benötigt werden.

Die konkrete Funktion bzw. Beleuchtungsanwendungen ist zum Produktions- oder auch Montagezeitpunkt einer LED-Leuchte frei wählbar, indem durch die mechanischen Schwächungen gebildete Substratbrücken unterbrochen bzw. herausgetrennt, d.h. ausgebrochen werden. Dies kann etwa durch ein Ausstanzen mittels eines speziellen Werkzeugs wie bspw. einem Stanzwerkzeug erfolgen (ggf. vorbereitet mittels vorgefertigter Schablonen) oder mittels eines Handwerkzeugs wie z.B. ein Schraubenzieher erfolgen, mit dem etwa bei der Montage der LED-Leuchte die durch die mechanischen Schwächungen gebildete Substratbrücken herausgetrennt werden können. Dadurch werden über die Substratbrücke geführte Leiterbahnen elektrisch unterbrochen. So ist es möglich, mehrere LED-Lichtquellen bei intakten Substratbrücken gemeinsam und bei ausgebrochenen Substratbrücken separat zu betreiben, etwa einen zentralen Spot und ein umgebendes Halo.

Eine vergleichbare Funktionalität auf Grundlage von Steckverbindern mit Jumpern wäre mit Kosten und Zuverlässigkeitsbedenken bezüglich dieser zusätzlichen Komponenten verbunden.

### KURZE BESCHREIBUNG DER FIGUREN

Die Erfindung wird nachfolgend anhand bevorzugter Ausführungsformen und unter Bezugnahme auf die Zeichnungen kurz erläutert, wobei gleiche Bezugszeichen gleiche oder ähnliche Elemente bezeichnen.
FIG. 1 und FIG. 2 illustrieren schematisch Leiterplatten 1 für ein LED-Modul 2 gemäß Ausführungsbeispielen.
FIG. 3 illustriert schematisch ein LED-Modul 2 gemäß einem Ausführungsbeispiel.
FIG. 4 - 7 illustrieren schematisch LED-Leuchten 3A - 3D gemäß Ausführungsbeispielen.

### DETAILLIERTE BESCHREIBUNG VON AUSFÜHRUNGSBEISPIELEN

Die Erfindung wird nachfolgend anhand bevorzugter Ausführungsformen und unter Bezugnahme auf die Zeichnungen näher erläutert.

Eine Beschreibung von Ausführungsbeispielen in spezifischen Anwendungsfeldern bedeutet keine Einschränkung auf diese Anwendungsfelder.

Elemente schematischer Darstellungen sind nicht notwendigerweise maßstabsgetreu wiedergegeben, sondern vielmehr derart, dass ihre Funktion und ihr Zweck dem Fachmann verständlich werden.

Soweit nicht ausdrücklich anders angegeben sind die Merkmale der verschiedenen Ausführungsformen miteinander kombinierbar.

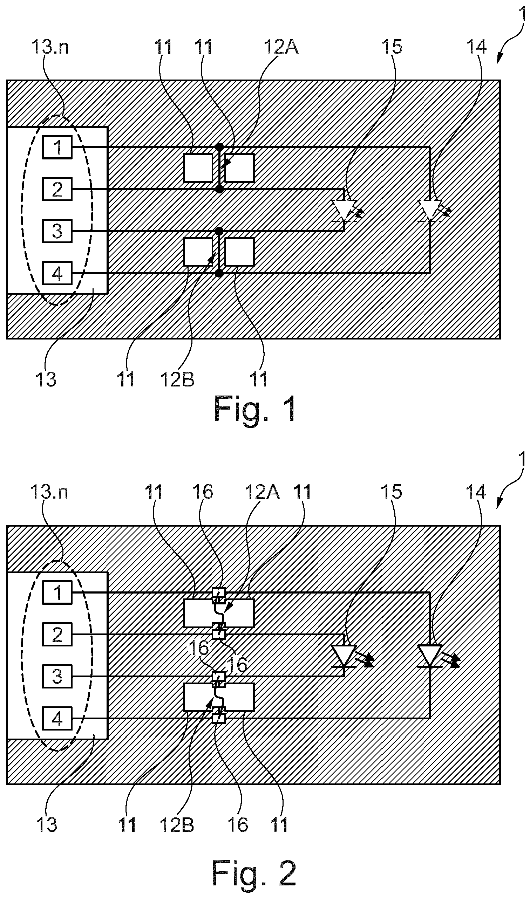

FIG. 1 illustriert schematisch eine Leiterplatte 1 für ein LED-Modul 2 gemäß einem ersten Ausführungsbeispiel.

Unter einer Leiterplatte kann ein Träger für elektronische Bauteile und deren elektrische Verbindung verstanden werden.

Unter einem LED-Modul kann eine elektrische Zusammenschaltung einer Mehrzahl von lichtemittierenden Dioden (LED) auf einem Träger, wie etwa einer Leiterplatte, verstanden werden.

Die Leiterplatte 1 umfasst einem Steckverbinder 13 mit vier Anschlüssen 13.1-13.4, welche in der FIG. 1 unter dem Bezugszeichen 13.n zusammengefasst und gestrichelt eingekreist sind. Die einzelnen Anschlüsse sind zur besseren Unterscheidung von *n =* 1 bis *n* = 4 fortlaufend durchnummeriert.

Zwischen einem ersten Anoden-Kathoden-Paar 13.1, 13.4 der vier Anschlüsse 13.1-13.4 ist eine erste LED-Lichtquelle 14 anschließbar, und zwischen einem zweiten Anoden-Kathoden-Paar 13.2, 13.3 der vier Anschlüsse 13.1-13.4 ist eine zweite LED-Lichtquelle 15 anschließbar. Hierbei sind die in Anoden bzw. Kathoden mündenden Enden der LED-Lichtquellen 14, 15 namensgebend.

Die in FIG. 1 gestrichelt angedeuteten LED-Lichtquellen 14, 15 können jeweils eine Anzahl parallelgeschalteter LED-Ketten umfassen.

Die Leiterplatte 1 umfasst ferner mechanische Schwächungen 11 in einem Substrat der Leiterplatte 1, welche in FIG. 1 beispielhaft als Ausnehmungen des Substrats (bzw. Öffnungen in dem Substrat) dargestellt sind, und die zumindest eine zumindest elektrisch unterbrechbare Substratbrücke 12A, 12B bilden. Mit anderen Worten wird also eine jeweilige Leiterbahn der Leiterplatte 1 über die jeweilige Substratbrücke 12A, 12B geführt. Weiterhin wären auch andere mechanische Schwächungen 11 etwa in Form von Langlöchern, Fräsnuten, Perforierungen o.ä. denkbar.

Die zumindest eine Substratbrücke 12A, 12B kann aus dem Substrat der Leiterplatte 1 ausstanzbar oder heraustrennbar sein. Dies kann etwa durch ein Ausstanzen mittels eines speziellen Werkzeugs wie bspw. einem Stanzwerkzeug bei der Produktion einer Leuchte erfolgen (ggf. vorbereitet mittels vorgefertigter Schablonen) oder durch ein Heraustrennen/-brechen mittels eines Handwerkzeugs wie z.B. einem Schraubenzieher oder einer Zange bei der Montage einer Leuchte. Dadurch ist eine konkrete Funktion bzw. Beleuchtungsanwendung zum Produktions- oder auch Montagezeitpunkt einer LED-Leuchte frei wählbar.

Ganz allgemein ist ein Anoden-Paar 13.1, 13.2 der vier Anschlüsse 13.1-13.4 über eine erste 12A der zumindest einen Substratbrücke 12A, 12B galvanisch miteinander verbunden.

Je nach Zustand der zumindest einen Substratbrücke 12A, 12B ist die Leiterplatte 1 durch den Steckverbinder 13 so über zwei oder drei separate galvanische Verbindungen an zumindest einen LED-Treiber für das LED-Modul 2 anschließbar.

Die zumindest eine Substratbrücke 12A, 12B kann zwei Substratbrücken 12A, 12B umfassen, wobei dann ein Kathoden-Paar 13.3, 13.4 der vier Anschlüsse 13.1-13.4 über eine zweite 12B der zumindest einen Substratbrücke 12A, 12B galvanisch miteinander verbunden sein kann.

Je nach Zustand der zumindest einen Substratbrücke 12A, 12B ist die Leiterplatte 1 dann durch den Steckverbinder 13 über zwei, drei oder vier separate galvanische Verbindungen an den zumindest einen LED-Treiber für das LED-Modul 2 anschließbar.

FIG. 2 illustriert schematisch eine Leiterplatte 1 für ein LED-Modul 2 gemäß einem zweiten Ausführungsbeispiel.

Die Leiterplatte 1 der FIG. 2 kann Lötanschlüsse 16 an Enden der jeweiligen Substratbrücke 12A, 12B zum nachträglichen galvanischen Überbrücken der jeweiligen Substratbrücke 12A, 12B umfassen.

Diese Lötanschlüsse 16 sind zum Produktionszeitpunkt als Testpunkte nutzbar, etwa für Endkontrollen, sowie zum Wiederverbinden von Schaltkreisen, die durch Unterbrechung der Substratbrücken 12A, 12B galvanisch getrennt wurden.

Das Wiederverbinden kann beispielsweise mittels Lötverbindungen erfolgen. Insbesondere kann die Leiterplatte 1 zumindest eine federbelastete Leiterbrücke zum nachträglichen galvanischen Überbrücken der jeweiligen Substratbrücke 12A, 12B zwischen den Lötanschlüssen 16 aufweisen.

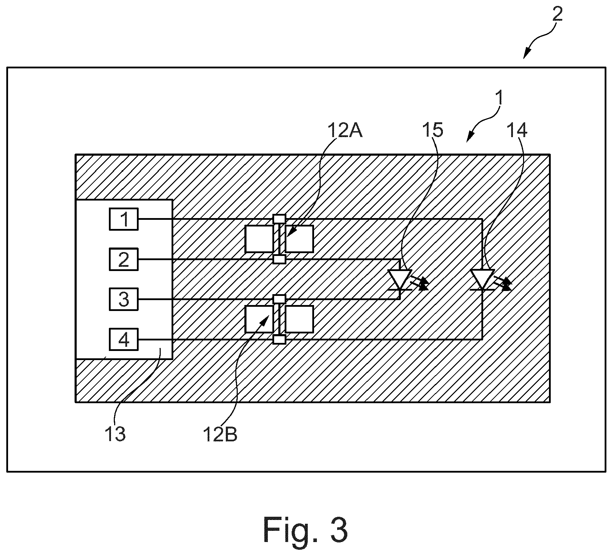

FIG. 3 illustriert schematisch ein LED-Modul 2 gemäß einem dritten Ausführungsbeispiel.

Das LED-Modul 2 umfasst eine zuvor näher ausgeführte Leiterplatte 1 sowie eine erste LED-Lichtquelle 14 und eine zweite LED-Lichtquelle 15.

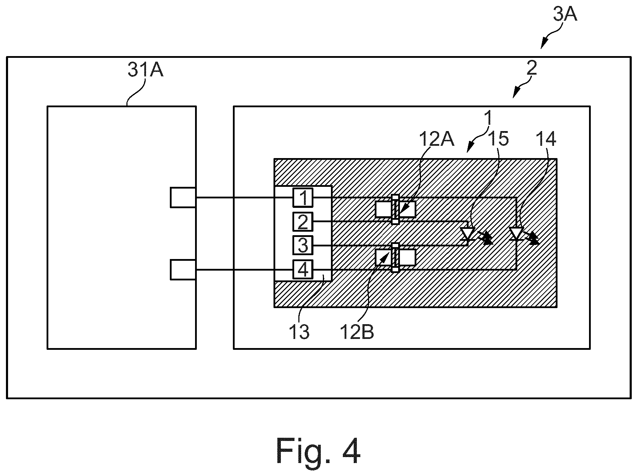

FIG. 4 illustriert schematisch eine LED-Leuchte 3A gemäß einem vierten Ausführungsbeispiel.

Unter einer LED-Leuchte kann eine elektrische Zusammenschaltung einer LED-Lichtquelle - wie etwa eines LED-Moduls - mit einer dafür geeigneten Treiberschaltung verstanden werden, die die zum Betrieb der LED-Lichtquelle erforderlichen Spannungen und/oder Ströme bereitstellt.

Die LED-Leuchte 3A umfasst ein zuvor näher ausgeführtes LED-Modul 2 mit zwei intakten Substratbrücken 12A, 12B.

Da das Anoden-Paar 13.1, 13.2 der vier Anschlüsse 13.1-13.4 über die erste 12A der zumindest einen Substratbrücke 12A, 12B und das Kathoden-Paar 13.3, 13.4 der vier Anschlüsse 13.1-13.4 über die zweite 12B der zumindest einen Substratbrücke 12A, 12B galvanisch miteinander verbunden sind, sich die beiden LED-Lichtquellen 14, 15 zueinander parallel geschaltet.

Die beiden LED-Lichtquellen 14, 15 sind in dieser Konfiguration gemeinsam betreibbar. Allerdings sollten die beiden LED-Lichtquellen 14, 15 für dieselbe Versorgungsspannung ausgelegt sein. Mit anderen Worten sollten die den beiden LED-Lichtquellen 14, 15 jeweils zugrundeliegenden LED-Ketten identisch aufgebaut sein.

Zum gemeinsamen Betreiben der ersten LED-Lichtquelle 14 und der zweiten LED-Lichtquelle 15 umfasst die LED-Leuchte 3A einem LED-Treiber 31A, der über zwei separate galvanische Verbindungen des Steckverbinders 13 der Leiterplatte 1 des LED-Moduls 2 angeschlossen ist.

Der Fachmann erkennt, dass es bezüglich der Verdrahtung des LED-Treibers 31A mit dem LED-Modul 2 mehrere Möglichkeiten gibt. So ist in FIG. 4 eine Verdrahtung über das Anschlusspaar 13.1/13.4 angegeben. Bei identischer Funktion der Leuchte 3A wären auch die Anschlusspaare 13.1/13.3, 13.2/13.3 sowie 13.2/13.4 möglich.

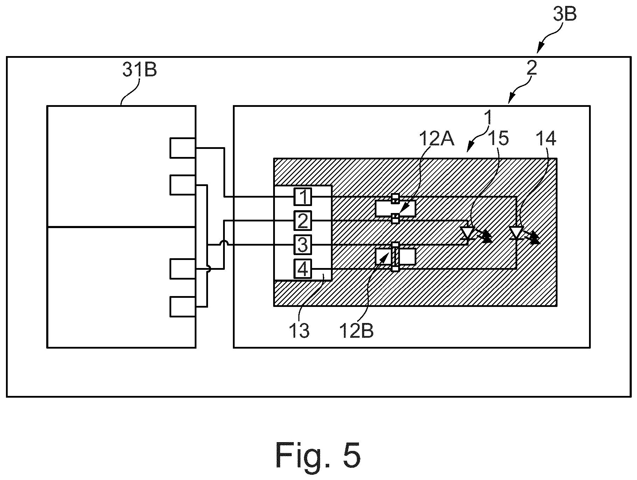

FIG. 5 illustriert schematisch eine LED-Leuchte 3B gemäß einem fünften Ausführungsbeispiel.

Die LED-Leuchte 3A umfasst ein zuvor näher ausgeführtes LED-Modul 2 mit unterbrochener erster Substratbrücke 12A der Substratbrücken 12A, 12B, und intakter zweiter Substratbrücke 12B der Substratbrücken 12A, 12B.

Insofern ist in diesem Ausführungsbeispiel nur noch das Kathoden-Paar 13.3, 13.4 der vier Anschlüsse 13.1-13.4 über die zweite 12B der zumindest einen Substratbrücke 12A, 12B galvanisch miteinander verbunden. Das bedeutet, dass die beiden LED-Lichtquellen 14, 15 über eine gemeinsame Massereferenz verfügen.

Die beiden LED-Lichtquellen 14, 15 sind in dieser Konfiguration separat betreibbar. Zum voneinander unabhängigen Betreiben der ersten LED-Lichtquelle 14 und der zweiten LED-Lichtquelle 15 umfasst die LED-Leuchte 3B einem Zweikanal-LED-Treiber 31B, der in dieser Ausführungsform über drei separate galvanische Verbindungen des Steckverbinders 13 der Leiterplatte 1 des LED-Moduls 2 angeschlossen ist. Das bedeutet, dass sich auch die beiden Kanäle des Zweikanal-LED-Treibers 31B die gemeinsame Massereferenz teilen.

Bezüglich der Verdrahtung des LED-Treibers 31B mit dem LED-Modul 2 wären neben der in FIG. 5 gezeigten Verdrahtung über die Anschlüsse 13.1/13.2/13.3 bei identischer Funktion der Leuchte 3B auch die Anschlüsse 13.1/13.2/13.4 wählbar.

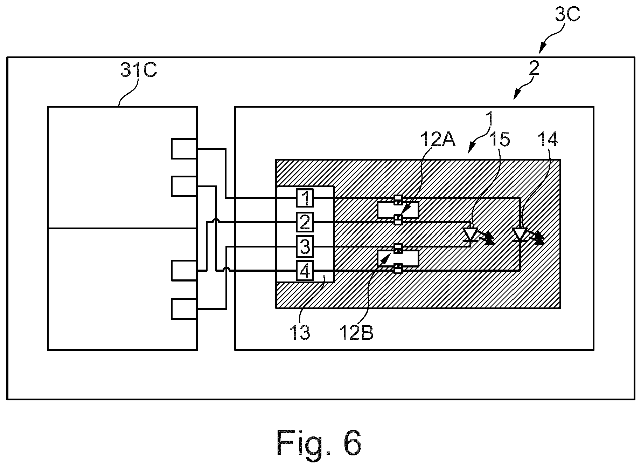

FIG. 6 illustriert schematisch eine LED-Leuchte 3C gemäß einem sechsten Ausführungsbeispiel.

Die LED-Leuchte 3C umfasst ein zuvor näher ausgeführtes LED-Modul 2, allerdings mit unterbrochenen Substratbrücken 12A, 12B.

Demzufolge sind in diesem Ausführungsbeispiel weder das Anoden-Paar 13.1, 13.2 der vier Anschlüsse 13.1-13.4 über die erste 12A der zumindest einen Substratbrücke 12A, 12B noch das Kathoden-Paar 13.3, 13.4 der vier Anschlüsse 13.1-13.4 über die zweite 12B der zumindest einen Substratbrücke 12A, 12B galvanisch miteinander verbunden.

Die beiden LED-Lichtquellen 14, 15 sind in dieser Konfiguration separat betreibbar und umfassend galvanisch getrennt. Zum voneinander unabhängigen Betreiben der ersten LED-Lichtquelle 14 und der zweiten LED-Lichtquelle 15 umfasst die LED-Leuchte 3C einen Zweikanal-LED-Treiber 31C, der in dieser Ausführungsform über zwei separate Paare von galvanischen Verbindungen des Steckverbinders 13 der Leiterplatte 1 des LED-Moduls 2 angeschlossen ist.

Bezüglich der Verdrahtung des LED-Treibers 31C mit dem LED-Modul 2 besteht - bei geeigneten elektrischen Gegebenheiten - lediglich die Möglichkeit, eine Zuordnung der Kanäle des LED-Treibers 31C zu den LED-Lichtquellen 14, 15 zu vertauschen.

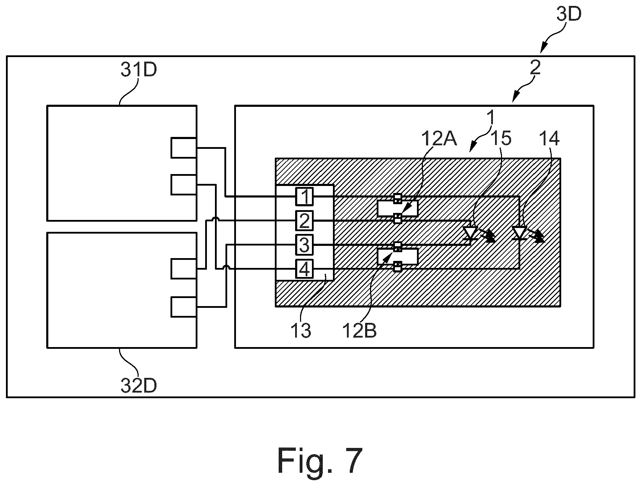

FIG. 7 illustriert schematisch eine LED-Leuchte 3D gemäß einem siebten Ausführungsbeispiel.

Die LED-Leuchte 3D weist wie die zuvor näher ausgeführte LED-Leuchte 3C aus FIG. 6 ein LED-Modul 2 mit unterbrochenen Substratbrücken 12A, 12B auf, allerdings in Kombination mit separaten ersten und zweiten LED-Treibern 31D, 32D zum voneinander unabhängigen Betreiben der ersten LED-Lichtquelle 14 und der zweiten LED-Lichtquelle 15. Diese ersetzen die Kanäle des LED-Treibers 31C und sind wiederum über zwei separate Paare von galvanischen Verbindungen des Steckverbinders 13 der Leiterplatte 1 des LED-Moduls 2 angeschlossen.

## Patentansprüche

1. Leiterplatte (1) für ein LED-Modul (2), mit
einem Steckverbinder (13) mit vier Anschlüssen (13.1-13.4);
wobei zwischen einem ersten Anoden-Kathoden-Paar (13.1, 13.4) der vier Anschlüsse (13.1-13.4) eine erste LED-Lichtquelle (14) anschließbar ist;
wobei zwischen einem zweiten Anoden-Kathoden-Paar (13.2, 13.3) der vier Anschlüsse (13.1-13.4) eine zweite LED-Lichtquelle (15) anschließbar ist;
**gekennzeichnet durch**
mechanischen Schwächungen (11) in einem Substrat der Leiterplatte (1), die zumindest eine zumindest elektrisch unterbrechbare Substratbrücke (12A, 12B) bilden;
wobei ein Anoden-Paar (13.1, 13.2) der vier Anschlüsse (13.1-13.4) über eine erste (12A) der zumindest einen Substratbrücke (12A, 12B) galvanisch miteinander verbunden ist;
wobei die Leiterplatte (1) durch den Steckverbinder (13) je nach Zustand der zumindest einen Substratbrücke (12A, 12B) über zwei oder drei separate galvanische Verbindungen an zumindest einen LED-Treiber für das LED-Modul (2) anschließbar ist.

2. Leiterplatte (1) nach Anspruch 1,
wobei die zumindest eine Substratbrücke (12A, 12B) aus dem Substrat der Leiterplatte (1) ausstanzbar oder heraustrennbar ist.

3. Leiterplatte (1) nach Anspruch 1 oder Anspruch 2, mit
Lötanschlüssen (16) an Enden der jeweiligen Substratbrücke (12A, 12B) zum nachträglichen galvanischen Überbrücken der jeweiligen Substratbrücke (12A, 12B).

4. Leiterplatte (1) nach Anspruch 3, mit
zumindest einer federbelasteten Leiterbrücke zum nachträglichen galvanischen Überbrücken der jeweiligen Substratbrücke (12A, 12B) zwischen den Lötanschlüssen (16).

5. Leiterplatte (1) nach einem der vorhergehenden Ansprüche,
wobei die zumindest eine Substratbrücke (12A, 12B) zwei Substratbrücken (12A, 12B) umfasst;
wobei ein Kathoden-Paar (13.3, 13.4) der vier Anschlüsse (13.1-13.4) über eine zweite (12B) der zumindest einen Substratbrücke (12A, 12B) galvanisch miteinander verbunden ist; und
wobei die Leiterplatte (1) durch den Steckverbinder (13) je nach Zustand der zumindest einen Substratbrücke (12A, 12B) über zwei, drei oder vier separate galvanische Verbindungen an den zumindest einen LED-Treiber für das LED-Modul (2) anschließbar ist.

6. LED-Modul (2), mit
einer Leiterplatte (1) nach Anspruch 5 mit
der ersten LED-Lichtquelle (14); und
der zweiten LED-Lichtquelle (15).

7. LED-Leuchte (3A), mit
einem LED-Modul (2) nach Anspruch 6 mit intakten Substratbrücken (12A, 12B); und
einem LED-Treiber (31A) zum gemeinsamen Betreiben der ersten LED-Lichtquelle (14) und der zweiten LED-Lichtquelle (15);
wobei der LED-Treiber (31A) über zwei separate galvanische Verbindungen des Steckverbinders (13) der Leiterplatte (1) des LED-Moduls (2) angeschlossen ist.

8. LED-Leuchte (3B), mit
einem LED-Modul (2) nach Anspruch 6 mit unterbrochener erster Substratbrücke (12A) der Substratbrücken (12A, 12B); und
einem Zweikanal-LED-Treiber (31B) zum voneinander unabhängigen Betreiben der ersten LED-Lichtquelle (14) und der zweiten LED-Lichtquelle (15);
wobei der LED-Treiber (31B) über drei separate galvanische Verbindungen des Steckverbinders (13) der Leiterplatte (1) des LED-Moduls (2) angeschlossen ist.

9. LED-Leuchte (3C), mit
einem LED-Modul (2) nach Anspruch 6 mit unterbrochenen Substratbrücken (12A, 12B); und
einem Zweikanal-LED-Treiber (31C) zum voneinander unabhängigen Betreiben der ersten LED-Lichtquelle (14) und der zweiten LED-Lichtquelle (15);
wobei der LED-Treiber (31C) über zwei separate Paare von galvanischen Verbindungen des Steckverbinders (13) der Leiterplatte (1) des LED-Moduls (2) angeschlossen ist.

10. LED-Leuchte (3D), mit
einem LED-Modul (2) nach Anspruch 6 mit unterbrochenen Substratbrücken (12A, 12B); und
separaten ersten und zweiten LED-Treibern (31D, 32D) zum voneinander unabhängigen Betreiben der ersten LED-Lichtquelle (14) und der zweiten LED-Lichtquelle (15);
wobei die LED-Treiber (31D, 32D) über zwei separate Paare von galvanischen Verbindungen des Steckverbinders (13) der Leiterplatte (1) des LED-Moduls (2) angeschlossen sind.

## Claims

1. Printed circuit board (1) for an LED module (2), comprising
a plug connector (13) which has four terminals (13.1-13.4);
wherein a first LED light source (14) can be connected between a first anode-cathode pair (13.1, 13.4) of the four terminals (13.1-13.4);
wherein a second LED light source (15) can be connected between a second anode-cathode pair (13.2, 13.3) of the four terminals (13.1-13.4);
**characterized by**
mechanical weakenings (11) in a substrate of the printed circuit board (1) which form at least one at least electrically interruptible substrate bridge (12A, 12B);
wherein a pair of anodes (13.1, 13.2) of the four terminals (13.1-13.4) is galvanically interconnected via a first (12A) of the at least one substrate bridge (12A, 12B);
wherein the printed circuit board (1) can be connected by means of the plug connector (13) to at least one LED driver for the LED module (2) via two or three separate galvanic connections depending on the state of the at least one substrate bridge (12A, 12B).

2. Printed circuit board (1) according to claim 1,
wherein the at least one substrate bridge (12A, 12B) can be punched out of or separated from the substrate of the printed circuit board (1).

3. Printed circuit board (1) according to claim 1 or claim 2, comprising
soldering connections (16) at ends of the relevant substrate bridge (12A, 12B) for subsequent galvanic bridging of the relevant substrate bridge (12A, 12B).

4. Printed circuit board (1) according to claim 3, comprising
at least one spring-loaded conductor bridge for subsequent galvanic bridging of the relevant substrate bridge (12A, 12B) between the soldering connections (16).

5. Printed circuit board (1) according to any of the preceding claims,
wherein the at least one substrate bridge (12A, 12B) comprises two substrate bridges (12A, 12B);
wherein a pair of cathodes (13.3, 13.4) of the four terminals (13.1-13.4) is galvanically interconnected via a second (12B) of the at least one substrate bridge (12A, 12B); and
wherein the printed circuit board (1) can be connected by means of the plug connector (13) to the at least one LED driver for the LED module (2) via two, three or four separate galvanic connections depending on the state of the at least one substrate bridge (12A, 12B).

6. LED module (2) comprising
a printed circuit board (1) according to claim 5 having
the first LED light source (14); and
the second LED light source (15).

7. LED light (3A) comprising
an LED module (2) according to claim 6 having intact substrate bridges (12A, 12B); and
an LED driver (31A) for jointly operating the first LED light source (14) and the second LED light source (15);
wherein the LED driver (31A) is connected via two separate galvanic connections of the plug connector (13) of the printed circuit board (1) of the LED module (2).

8. LED light (3B) comprising
an LED module (2) according to claim 6 having an interrupted first substrate bridge (12A) of the substrate bridges (12A, 12B); and
a two-channel LED driver (31B) for operating the first LED light source (14) and the second LED light source (15) independently of one another;
wherein the LED driver (31B) is connected via three separate galvanic connections of the plug connector (13) of the printed circuit board (1) of the LED module (2).

9. LED light (3C) comprising
an LED module (2) according to claim 6 having interrupted substrate bridges (12A, 12B);
and
a two-channel LED driver (31C) for operating the first LED light source (14) and the second LED light source (15) independently of one another;
wherein the LED driver (31C) is connected via two separate pairs of galvanic connections of the plug connector (13) of the printed circuit board (1) of the LED module (2).

10. LED light (3D) comprising
an LED module (2) according to claim 6 having interrupted substrate bridges (12A, 12B); and
separate first and second LED drivers (31D, 32D) for operating the first LED light source (14) and the second LED light source (15) independently of one another;
wherein the LED drivers (31D, 32D) are connected via two separate pairs of galvanic connections of the plug connector (13) of the printed circuit board (1) of the LED module (2).

## Revendications

1. Carte de circuit imprimé (1) pour un module **DEL** (2), comportant
un connecteur à fiches (13) comportant quatre branchements (13.1-13.4) ;
dans laquelle une première source de lumière **DEL** (14) peut être branchée entre une première paire anode-cathode (13.1, 13.4) parmi les quatre branchements (13.1-13.4) ;
dans laquelle une seconde source de lumière **DEL** (15) peut être branchée entre une seconde paire anode-cathode (13.2, 13.3) parmi les quatre branchements (13.1-13.4) ;
**caractérisée par**
des affaiblissements mécaniques (11) dans un substrat de la carte de circuit imprimé (1), lesquels forment au moins un pont de substrat (12A, 12B) pouvant être interrompu au moins électriquement ;
dans laquelle une paire d'anodes (13.1, 13.2) parmi les quatre branchements (13.1-13.4) sont connectées galvaniquement entre elles par l'intermédiaire d'un premier pont de substrat (12A) parmi l'au moins un pont de substrat (12A, 12B) ;
dans laquelle la carte de circuit imprimé (1) peut être branchée par le connecteur à fiches (13), selon un état de l'au moins un pont de substrat (12A, 12B), par l'intermédiaire de deux ou trois connexions galvaniques séparées, à au moins un pilote DEL pour le module DEL (2).

2. Carte de circuit imprimé (1) selon la revendication 1,
dans laquelle l'au moins un pont de substrat (12A, 12B) peut être découpé ou séparé du substrat de la carte de circuit imprimé (1).

3. Carte de circuit imprimé (1) selon la revendication 1 ou la revendication 2, comportant
des branchements soudés (16) aux extrémités du pont de substrat (12A, 12B) respectif pour le pontage galvanique ultérieur du pont de substrat (12A, 12B) respectif.

4. Carte de circuit imprimé (1) selon la revendication 3, comportant
au moins un pont conducteur chargé par ressort pour le pontage galvanique ultérieur du pont de substrat (12A, 12B) respectif entre les branchements soudés (16).

5. Carte de circuit imprimé (1) selon l'une des revendications précédentes,
dans laquelle l'au moins un pont de substrat (12A, 12B) comprend deux ponts de substrat (12A, 12B) ;
dans laquelle une paire de cathodes (13.3, 13.4) parmi les quatre branchements (13.1-13.4) sont connectées galvaniquement l'une à l'autre par l'intermédiaire d'un second pont de substrat (12B) parmi l'au moins un pont de substrat (12A, 12B) ; et
dans laquelle la carte de circuit imprimé (1) peut être branchée par le connecteur à fiches (13), selon un état de l'au moins un pont de substrat (12A, 12B), par l'intermédiaire de deux, trois ou quatre connexions galvaniques séparées, à au moins un pilote DEL pour le module DEL (2).

6. Module DEL (2), comportant
une carte de circuit imprimé (1) selon la revendication 5, comportant
la première source de lumière DEL (14) ; et
la seconde source de lumière DEL (15).

7. Lampe DEL (3A), comportant
un module DEL (2) selon la revendication 6 comportant des ponts de substrat (12A, 12B) intacts ; et
un pilote DEL (31A) permettant de faire fonctionner conjointement la première source de lumière DEL (14) et la seconde source de lumière DEL (15) ;
dans laquelle le pilote DEL (31A) est branché par l'intermédiaire de deux connexions galvaniques séparées du connecteur à fiches (13) de la carte de circuit imprimé (1) du module DEL (2).

8. Lampe DEL (3B), comportant
un module DEL (2) selon la revendication 6, comportant un premier pont de substrat (12A) interrompu parmi les ponts de substrat (12A, 12B) ; et
un pilote DEL à deux canaux (31B) permettant de faire fonctionner la première source de lumière DEL (14) et la seconde source de lumière DEL (15) indépendamment l'une de l'autre ;
dans laquelle le pilote DEL (31B) est branché par l'intermédiaire de trois connexions galvaniques séparées du connecteur à fiches (13) de la carte de circuit imprimé (1) du module DEL (2).

9. Lampe DEL (3C), comportant
un module DEL (2) selon la revendication 6, comportant des ponts de substrat (12A, 12B) interrompus ;
et
un pilote DEL à deux canaux (31C) permettant de faire fonctionner la première source de lumière DEL (14) et la seconde source de lumière DEL (15) indépendamment l'une de l'autre ;
dans laquelle le pilote DEL (31C) est branché par l'intermédiaire de deux paires de connexions galvaniques séparées du connecteur à fiches (13) de la carte de circuit imprimé (1) du module DEL (2).

10. Lampe DEL (3D), comportant
un module DEL (2) selon la revendication 6, comportant des ponts de substrat (12A, 12B) interrompus ; et
de premiers et de seconds pilotes DEL (31D, 32D) séparés permettant de faire fonctionner la première source de lumière DEL (14) et la seconde source de lumière DEL (15) indépendamment l'une de l'autre ;
dans laquelle le pilote DEL (31D, 32D) est branché par l'intermédiaire de deux paires de connexions galvaniques séparées du connecteur à fiches (13) de la carte de circuit imprimé (1) du module DEL (2).
